# EUROPÄISCHE PATENTSCHRIFT

(11) **EP 0 293 723 B1**
(45) Veröffentlichungstag und Bekanntmachung des Hinweises auf die Patenterteilung: **28.12.1994**
(21) Anmeldenummer: 88108267.1
(22) Anmeldetag: 24.05.1988
(51) Int. Cl.: G01R 33/38, G01R 33/42

(54) **Magnetspulensystem einer Anlage zur Kernspintomographie mit supraleitenden Grundfeldspulen und einem Strahlungsschild**
Magnetic coil system of an NMR imaging system, with superconducting coils and a shield for protection against eddy currents
Système de bobines magnétiques d'une installation pour l'imagerie RMN, muni de bobines supraconductrices et d'un écran protégeant des rayonnements parasites

(30) Priorität: 04.06.1987 DE 3718755
(43) Veröffentlichungstag der Anmeldung: 07.12.1988
(73) Patentinhaber: SIEMENS AKTIENGESELLSCHAFT, 80333 München (DE)
(72) Erfinder: Siebold, Horst, Dr., D-8520 Erlangen (DE); Ries, Günther, Dr., D-8520 Erlangen (DE)

(56) Entgegenhaltungen:
- EP-A- 0 123 075
- EP-A- 0 151 719
- EP-A- 0 151 726
- DE-A- 3 301 630
- US-A- 4 268 353
- REVIEW OF SCIENTIFIC INSTRUMENTS vol. 53, no. 4, April 1982, Seiten 485-490, New York, US; K.A. MUETHING et al.: "Small solenoid with a superconduction shield for nuclear-magnetic-resonance near 1 mk"
- PHYSICS TODAY April 1987, Seiten 17-23; A. KHURANA: "Superconductivity seen above the boiling point of nitrogen"
- SUPRALEITUNG 3. Auflage, 1984, Seiten 140-166, Weinheim; W. BUCKEL

## Beschreibung

Die Erfindung bezieht sich auf ein Magnetspulensystem einer Anlage zur Kernspintomographie mit supraleitenden Spulen zur Erzeugung eines homogenen magnetischen Grundfeldes, mit normalleitenden Spulen innerhalb des von den Grundfeldspulen umgrenzten Innenraumes zur Ausbildung magnetischer Feldgradienten sowie mit mindestens einem gekühlten Strahlungsschild aus elektrisch und thermisch leitendem Material, der zwischen den Gradientenspulen und den supraleitenden Grundfeldspulen angeordnet ist. Ein derartiges Magnetspulensystem ist in der EP-A-0 144 171 angedeutet.

Auf dem Gebiet der medizinischen Technik sind bildgebende Diagnoseverfahren entwickelt worden, bei denen rechnerisch oder meßtechnisch integrale Resonanzsignale von Kernen eines bestimmten chemischen Elementes eines zu untersuchenden, insbesondere menschlichen Körpers oder Körperteiles analysiert werden. Aus der so zu gewinnenden räumlichen Spindichte- und/oder Relaxationszeitverteilung läßt sich dann ein Bild ähnlich einem Röntgentomogramm der Computertomographie rekonstruieren bzw. berechnen. Entsprechende Verfahren sind allgemein unter der Bezeichnung "Kernspintomographie" oder "NMR-Tomographie" (Nuclear Magnetic Resonance Tomography, vielfach auch als "Magnetic Resonance Imaging - MRI" oder "Magnetic Resonance Spectroscopy - MRS" bezeichnet) bekannt.

Voraussetzung für die Kernspintomographie ist ein von einem sogenannten Grundfeldmagneten erzeugtes Magnetfeld, in das ein zu untersuchender Körper bzw. Körperteil längs einer Achse, die im allgemeinen mit der Orientierungsachse des magnetischen Grundfeldes übereinstimmt, eingebracht wird. Das Grundfeld muß in einem entsprechenden Abbildungs- bzw. Untersuchungsbereich hinreichend homogen sein, wobei seine magnetische Induktion dort bis zu mehreren Tesla betragen kann. Solch hohe magnetische Induktionen lassen sich wirtschaftlich jedoch nur mit supraleitenden Magnetspulen erzeugen, die in einem entsprechenden Kryosystem unterzubringen sind. Ein solches Kryosystem umfaßt auch mindestens einen gekühlten Strahlungsschild, um eine Wärmeeinleitung von Raumtemperatur auf die supraleitenden Grundfeldspulen zu begrenzen. Derartige Strahlungsschilde werden aus thermischen Gründen im allgemeinen aus thermisch und damit auch aus elektrisch gut-leitendem Material erstellt. Das magnetische Grundfeld wird von stationären und/oder gepulsten, sogenannten Gradientenfeldern überlagert, welche von normalleitenden Spulen hervorgerufen werden, die innerhalb des von dem Kryosystem der Grundfeldspulen umgrenzten Innenraumes angeordnet sind und im allgemeinen auf etwa Raumtemperatur liegen. Zur Anregung der einzelnen Atomkerne in dem Körper bzw. Körperteil zu einer Präzessionsbewegung ist außerdem eine besondere Antenneneinrichtung erforderlich, mit der kurzfristig ein hochfrequentes magnetisches Wechselfeld erzeugt werden kann. Gegebenenfalls läßt sich diese Antenneneinrichtung auch zum Empfang der so von den angeregten Atomkernen hervorgerufenen hochfrequenten Signale vorsehen.

Gemäß der eingangs genannten EP-A ist der Strahlungsschild eines supraleitenden Grundfeldspulensystems bzw. seines Kryosystems aus einem elektrisch gut-leitenden Material wie z.B. Aluminium erstellt. In einem solchen Strahlungsschild werden jedoch von den normalleitenden Gradientenspulen Wirbelströme induziert, die ihrerseits wieder rückwirkend Gradientenfelder im Nutzvolumen des Untersuchungsbereiches erzeugen. Wegen der endlichen Leitfähigkeit der allgemein verwendeten Strahlungsschilde klingen diese Wirbelströme mit einer Zeitkonstanten τ ab, die im allgemeinen zwischen 0,05 sec und 0,3 sec liegt. Dies führt zu einer Pulsverzerrung des Gradientenfeldes, bzw. es stellt sich unterhalb einer Grenzfrequenz f_{g} ein zu niedrigen Frequenzen f < f_{g} = (2π τ)⁻¹ hin ansteigender Frequenzgang der Empfindlichkeit des Spulensystems, definiert als Gradientenfeldstärke pro Betriebsstrom, ein. Ohne besondere Gegenmaßnahmen bewirkt dies aber eine Bildunschärfe in der Kernspintomographie. In diesem Zusammenhang ist es im allgemeinen auch nicht praktikabel, die Strahlungsschilde nicht-schirmend z.B. durch elektrisch schlecht-leitendes Material oder mit einer Schlitzung auszuführen. Dann könnten nämlich die Gradientenfelder bis in den heliumkalten Bereich der supraleitenden Grundfeldspulen dringen und dort bei der sehr tiefen Temperatur besonders störende Wärme produzieren.

Im Zusammenhang mit dieser Problematik sind hauptsächlich zwei Gegenmaßnahmen bekannt:
1. Das Magnetfeld der in einem entsprechenden Strahlungsschild induzierten Wirbelströme beträgt etwa 10 bis 30 % des direkten Gradientenfeldes und ist im wesentlichen wiederum ein Gradientenfeld, welches dem ursprünglichen entgegengesetzt ist, es also abschwächt. Dieser Effekt kann bei der Auslegung und Gestaltung der Gradientenspulen berücksichtigt werden, so daß zusammen wiederum ein Gradientenfeld hoher räumlicher Qualität entsteht (vgl. z.B. "J.Phys.E", Vol. 19, 1986, Seiten 876 bis 87). Hierzu kann man durch eine Frequenzgangkorrektur der die Gradientenspulen speisenden Strompulse den Frequenzgang der Wirbelströme kompensieren. Im allgemeinen muß aber eine solche Korrektur individuell für jedes Magnetsystem gesondert eingestellt werden, da die Leitfähigkeit der als Strahlungsschild eingesetzten Bleche bei tiefen Temperaturen streut. Außerdem kann nicht sichergestellt werden, daß die räumliche Verteilung der Wirbelströme beim Abklingen unverändert bleibt. D.h., die bei dieser Gegenmaßnahme vorausgesetzte Separierbarkeit von Raum- und Zeitverhalten des Gradientenfeldes bezüglich des Strahlungsschildes ist nicht ohne weiteres gegeben.
   Zur Vereinfachung dieser Gegenmaßnahme ist aus IEEE Transactions on Magnetics, Band MAG-23, Nr.2, März 1987, Seiten 1287-1293, die Verwendung eines massiven Wirbelstromschildes aus Kupfer bekannt. Die Abschirmung befindet sich im Kryostaten auf einer Temperatur von 77K und bewirkt, daß eine einzelne Abklingzeitkonstante dominiert, welche dann von den Gradientenspulen-Verstärkern zu Kompensieren ist.
2. Als weitere Gegenmaßnahme ist es z.B. aus "J.Phys.D", Vol. 19, 1986, Seiten L129 bis L131 bekannt, ein zusätzliches System von Gradientenspulen einzuführen, welches zwischen dem eigentlichen, primären Gradientenspulensystem und dem Strahlungsschild möglichst dicht an diesem Schild angeordnet wird. Hiermit läßt sich zwar vorteilhaft ein zumindest weitgehend glatter Frequenzgang erreichen. Zu Schwierigkeiten führen aber die beengten Platzverhältnisse im Inneren der im allgemeinen solenoidartigen supraleitenden Grundfeldspulen. Dann liegt nämlich jede negativ durchflutete zusätzliche Gradientenspule sehr nahe bei der entsprechenden primären Spule, da ja nur etwa 20 % größere Radien möglich sind. Dies hat zur Folge, daß die Gradientenfeldwirkung sich zu einem großen Teil wieder aufhebt und deshalb deutlich höhere Speisespannungen und -ströme notwendig sind als bei der vorstehend unter 1) erläuterten Gegenmaßnahme. Dies ist darauf zurückzuführen, daß in einem gemäß Gegenmaßnahme 1 ausgelegten Magnetspulensystem die in dem kalten und somit hochleitfähigen Strahlungsschild passiv angeworfenen Wirbelströme weniger Joule'sche Leistung kosten als die in den zusätzlichen, auf etwa Raumtemperatur befindlichen Gradientenspulen hervorgerufenen Ströme. Ferner ist auch die induktive Blindleistung bei Gegenmaßnahme 1 kleiner, da der Strahlungsschild sich radial weiter außen befindet als die zusätzlichen Gradientenspulen gemäß Gegenmaßnahme 2. Bei den heutigen und zukünftigen Pulsfolgen, insbesondere zur schnellen Bildgebung, werden jedoch immer stärkere Gradientenfelder gefordert, so daß die Leistungselektronik zur Speisung der Gradientenspulen insbesondere im Fall der Gegenmaßnahme 2 zu einem entsprechenden kostenträchtigen Teil des Gesamtsystems wird.

Aufgabe der vorliegenden Erfindung ist es deshalb, das Magnetspulensystem der eingangs genannten Art dahingehend auszugestalten, daß die bei den bekannten Gegenmaßnahmen auftretenden Probleme aufgrund von Wirbelstrombildungen in dem Strahlungsschild verringert sind. Dabei soll die Stärke und die Homogenität des Grundfeldes zumindest weitgehend unverändert bleiben.

Diese Aufgabe wird erfindungsgemäß mit den im Kennzeichen des Hauptanspruches angegebenen Maßnahmen gelöst.

Unter einem supraleitenden Material 2. Art wird hierbei allgemein jedes Material verstanden, das während des ungestörten Betriebszustandes des Magnetspulensystems im stationären Feld der Grundfeldspulen und in dem Wechselfeld der Gradienten- und HF-Spulen eine hinreichende Stromdichte (Stromtragfähigkeit) aufweist, um die in ihm induzierten Ströme zumindest weitgehend verlustfrei tragen zu können, ohne daß diese aufgrund eines elektrischen Widerstandes mit der Zeit abgeschwächt werden. Dabei soll das magnetische Grundfeld das supraleitende Material durchdringen können (vgl. z.B. Lehrbuch von W.Buckel: "Supraleitung", 3. Auflage, Weinheim 1984, Seiten 140 bis 166).

Die mit der erfindungsgemäßen Ausgestaltung des Magnetspulensystemes verbundenen Vorteile sind nun insbesondere darin zu sehen, daß der thermische Strahlungsschild gleichzeitig auch als Gradientenschirm wirkt. Dabei wird das Grundfeld wegen der Verwendung eines Supraleiters 2. Art nur geringfügig aufgrund eines geringen restlichen Diamagnetismus' aus dem Schirmmaterial herausgedrängt und damit im Nutzvolumen im Grundfeld des Magneten entsprechend wenig verändert. Die im Betriebsfall auftretenden Gradientenfelder werfen im supraleitenden Strahlungsschirm Ströme an, die nicht mehr durch Joule'sche Verluste gedämpft sind, so daß der Frequenzgang auch bis zu tiefsten Frequenzen weitgehend glatt ist. Die Vorteile der beiden erwähnten Gegenmaßnahmen sind also bei dem erfindungsgemäßen Magnetspulensystem praktisch vereinigt.

Ein zusätzlicher Vorteil besteht darin, daß sich nun die Strahlungsschilde des Magnetspulensystems mit zumindest in zirkularer Richtung elektrisch schlecht-leitenden, beispielsweise längsgeschlitzten metallischen Teilen wie z.B. Blechen aufbauen lassen. In solchen Blechen können dann bei einem eventuellen Quench des Grundfeldmagneten, d.h. bei einem unbeabsichtigten Übergang vom supraleitenden in den normalleitenden Zustand, vorteilhaft keine großen Wirbelströme und damit Kräfte entstehen.

Ein weiterer Vorteil ist darin zu sehen, daß zeitabhängige äußere Störfelder, die nach einem sogenannten Shimmen (Homogenisieren) des Grundfeldmagneten auftreten, weitgehend vom Nutzvolumen ferngehalten werden.

Vorteilhafte Ausgestaltungen des Magnetspulensystems nach der Erfindung gehen aus den Unteransprüchen hervor.

Zur weiteren Erläuterung der Erfindung wird nachfolgend auf die Zeichnung Bezug genommen, in deren Figuren 1 und 2 ein Magnetspulensystem nach der Erfindung mit einem Strahlungsschild angedeutet ist. Die Figuren 3 und 4 zeigen zwei erfindungsgemäße Ausbildungsmöglichkeiten für den Strahlungsschild. In den Figuren 5 und 6 ist je eine Beschichtungsmöglichkeit für einen solchen Strahlungsschild veranschaulicht. In den Figuren sind gleiche Teile mit demselben Bezugszeichen versehen.

Bei dem erfindungsgemäßen Magnetspulensystem wird von bekannten Ausführungsformen ausgegangen, wie sie für bildgebende Anlagen zur Kernspintomographie vorgesehen werden (vgl. z.B. die genannte EP-A-0 144 171). Ein solches Magnetspulensystem enthält dabei im allgemeinen mehrere Paare von supraleitenden Spulen zur Erzeugung eines magnetischen Grundfeldes in Richtung der z-Achse eines rechtwinkligen x-y-z-Koordinatensystems. Dieses Grundfeld ist in einem Abbildungsbereich, in dessen zentraler Mitte M sich der Koordinatenursprung dieses Koordinatensystems befinden soll, hinreichend homogen. Das Magnetspulensystem soll einen axialen Zugang zu diesem homogenen Abbildungsbereich erlauben; d.h. ein zu untersuchender, beispielsweise menschlicher Körper wird längs der z-Achse in den Feldbereich eingebracht. Entsprechende Magnetspulensysteme werden deshalb vorzugsweise rotationssymmetrisch aufgebaut.

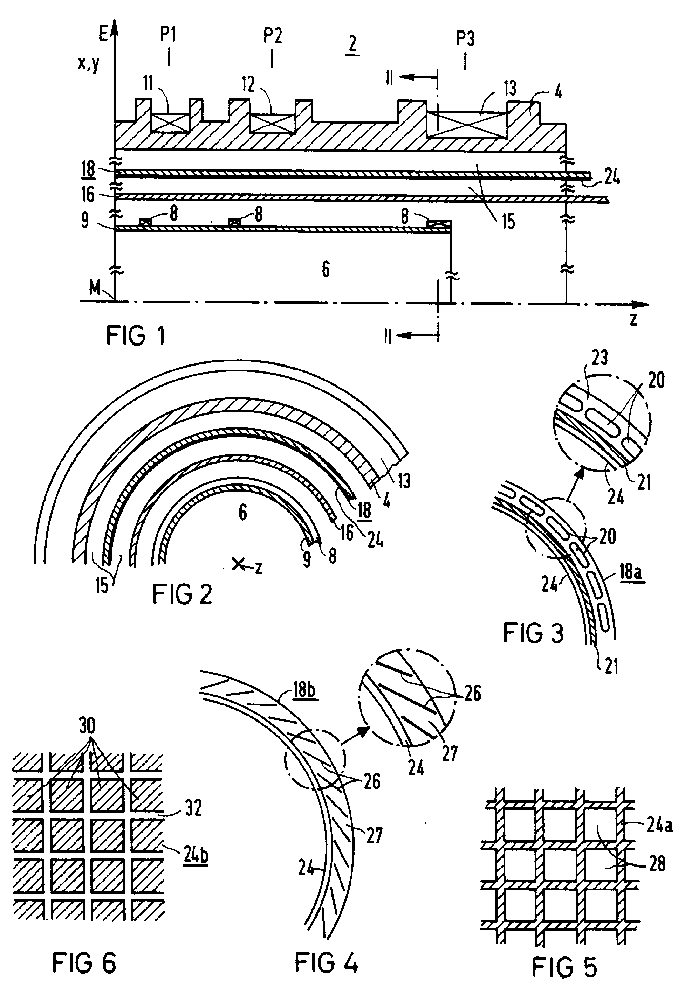

Das in Figur 1 nur schematisch als Längsschnitt teilweise angedeutete und allgemein mit 2 bezeichnete Magnetspulensystem zur Kernspintomographie soll z.B. sechs längs der z-Achse hintereinandergereihte, ringförmige supraleitende Grundfeldspulen aufweisen. Jeweils zwei dieser Spulen sind bezüglich der durch die x-y-Achse des Koordinatensystems aufgespannten Ebene E symmetrisch angeordnet, so daß sich drei Paare P1, P2 und P3 von Grundfeldspulen ergeben. In der Figur sind nur die auf der einen Seite dieser Symmetrieebene E und oberhalb der z-Achse liegenden Teile des Magnetspulensystems 2 näher ausgeführt. Es sind somit das Spulenpaar P1 durch seine Grundfeldspule 11, das Spulenpaar P2 durch seine Grundfeldspule 12 und das Spulenpaar P3 durch seine Grundfeldspule 13 veranschaulicht. Dabei können die Grundfeldspulen des Magnetspulensystems insbesondere in entsprechenden Nuten eines massiven, hohlzylindrischen Spulenkörpers 4 aus nicht-magnetischem Material angeordnet sein. Innerhalb des von den Spulenpaaren P1 bis P3 bzw. ihrem gemeinsamen Spulenkörper 4 begrenzten zylindrischen Innenraumes 6 des Magnetspulensystems 2 sind außerdem an sich bekannte normalleitende Gradientenspulen und ferner normalleitende HF-Spulen anzuordnen. In der Figur sind lediglich beispielsweise sattelförmige x-y-Gradientenspulen angedeutet und mit 8 bezeichnet. Diese beispielsweise auf einem rohrförmigen Träger befestigten Gradientenspulen 8 befinden sich etwa auf Raumtemperatur, so daß eine thermische Abschirmung zwischen ihnen und den tiefgekühlten supraleitenden Grundfeldspulen 11 bis 13 erforderlich ist. Hierzu dient ein im Querschnitt ringförmiger Vakuumraum 15 um den Spulenkörper 4. In diesem von einem entsprechenden Vakuumgefäß 16 eingeschlossenen Vakuumraum 15 ist konzentrisch mindestens ein vielfach auch als Kälteschild bezeichneter thermischer Strahlungsschild 18 angeordnet, der gemäß der Erfindung ausgebildet sein soll.

In Figur 2 ist schematisch ein Querschnitt durch das in Figur 1 gezeigte Magnetspulensystem 2 längs einer mit II-II bezeichneten Schnittebene wiedergegeben.

Gemäß der Erfindung soll der in den Figuren 1 und 2 gezeigte Strahlungsschild 18 mit supraleitendem Material 2. Art eines sogenannten Hoch-T_{c}-Supraleiters aufgebaut werden. Er muß dabei beim Auferregen der Grundfeldspulen 11 bis 13 wärmer sein als seine kritische Temperatur T_{c}, da sonst durch eine starke Flußverkopplung ein gegenläufiger zirkularer Strom induziert würde, der das magnetische Grundfeld in dem Innenbereich 6 schwächen will. Gegebenenfalls kann man zum Einstellen entsprechender Temperaturverhältnisse während der Auferregungsphase eine besondere Heizvorrichtung an dem Strahlungsschild vorsehen.

Abweichend davon ist es besonders vorteilhaft, wenn man während der Auferregungsphase der supraleitenden Grundfeldspulen den Strahlungsschild wenigstens weitgehend von einem eventuell vorhandenen Kältevorrat thermisch abkoppeln kann und die Grundfeldspulen erst nach einer solchen Maßnahme auferregt. Der supraleitende Belag auf dem Schild wirkt dann als Sekundärwicklung zu der Wicklung der Grundfeldspulen, in der ein zum Magnetstrom gegenläufiger Strom derart induziert wird, daß die magnetische Flußänderung im Magnetinneren Null bleibt. Die Dicke der supraleitenden Schicht wird nun vorteilhaft so bemessen, daß vor Erreichen des Magnetbetriebsstromes ihre Stromtragfähigkeit überschritten wird; dann dringt der magnetische Fluß in Form eines sogenannten Flußsprunges in den Innenraum des Schildes ein, die dabei freiwerdende magnetische Energie wärmt den ganzen Schild über die Sprungtemperatur T_{c} auf, und die supraleitenden Abschirmströme erlöschen. In diesem Ausführungsfall kann folglich auf eine separate Heizvorrichtung vorteilhaft verzichtet werden. Die Grundfeldspulen werden nun endgültig auf ihren Betriebsstrom gebracht, und der Strahlungsschild wird dann wieder thermisch an den Kältevorrat angekoppelt.

Falls der Strahlungsschild bauartbedingt nur schwachthermisch angekoppelt sein sollte, z.B. durch einen Strahlungsaustausch mit der Umgebung, entfällt selbstverständlich ein entsprechender thermischer Schaltvorgang.

Nach dem Ende der Auferregungsphase können dann die Grundfeldspulen in bekannter Weise in einen sogenannten "Dauerkurzschluß-Mode" gebracht werden; d.h., in dem Strahlungsschild werden dann keine zirkularen Wirbelströme mehr induziert. Er kann sich dann folglich auf seine Betriebstemperatur abkühlen, die natürlich unterhalb der kritischen Temperatur T_{c} liegen muß, damit er wieder in den supraleitenden Betriebszustand übergehen kann. Da es sich bei dem supraleitenden Material vorzugsweise um einen Supraleiter 2. Art handelt, wird das von den Grundfeldspulen erzeugte Magnetfeld nur geringfügig aufgrund seines geringen Diamagnetismus' beeinträchtigt. Vorteilhaft tritt auch keine Bedämpfung der von den Gradientenfeldern in dem supraleitenden Strahlungsschild angeworfenen Wirbelströme auf.

Die Strahlungsschilde von heliumgekühlten supraleitenden Magnetspulen wie z.B. aus NbTi- oder Nb₃Sn-Supraleitern liegen im allgemeinen auf Temperaturniveaus zwischen 20 K und 80 K. Sie werden entweder mit Helium-Abgas oder mit flüssigem Stickstoff direkt gekühlt. Auch ist eine thermische Ankopplung ihrer Stirnseiten an entsprechend kalte Teile der Magnetspulen möglich. Für die erfindungsgemäße Ausbildung dieser Strahlungsschilde eignen sich deshalb besonders vorteilhaft Supraleiter aus Metalloxidverbindungen auf der Basis Me1-Me2-Cu-O mit hohen Sprungtemperaturen T_{c} (vgl. z.B. "Physics Today", April 1987, Seiten 17 bis 23). Me1 sind dabei spezielle Seltene Erden wie z.B. La oder Y, während Me2 spezielle Erdalkalimetalle wie Ba, Sr oder Ca sind. So werden z.B. für das System Y-Ba-Cu-O Sprungtemperaturen um 90 K beobachtet ("Journal of the American Chemical Society", Vol. 109, No. 9 , 1987, Seiten 2848 und 284). Die supraleitenden Phasen dieser Materialien haben dabei eine Struktur ähnlich einer Oxidkeramik, so daß diese Supraleiter auch als keramische Supraleiter bezeichnet werden. Diese Hoch-T_{c}-Supraleiter zeigen auch ein Verhalten in einem äußeren Magnetfeld entsprechend den bekannten Supraleitern 2. Art; d.h., sie schirmen die magnetische Feldstärke nur bis zu einem unteren kritischen Wert H_{c1} ab. Für Feldstärken zwischen H_{c1} und einem oberen kritischen Wert H_{c2} kann hingegen das äußere Feld in den Supraleiter eindringen, ohne daß dabei die Supraleitungseigenschaft zerstört wird. Erst bei Feldstärken oberhalb von H_{c2} wird der Normalzustand erzwungen.

Mit dem Material eines solchen Hoch-T_{c} -Supraleiters soll nun gemäß der Erfindung der Strahlungsschild ausgestattet sein. Ein Teil eines entsprechenden Strahlungsschildes ist in Figur 3 als Querschnitt schematisch veranschaulicht und mit 18a bezeichnet. Dieser Schirm setzt sich im wesentlichen aus einer Vielzahl von dünnwandigen Rohren zusammen, die z.B. aus Edelstahl bestehen. Diese Rohre erstrecken sich untereinander parallelliegend in axialer (z-) Richtung und liegen in Umfangsrichtung gesehen eng nebeneinander. Jedoch sollen sie untereinander vorteilhaft isoliert sein. Gemäß dem dargestellten Ausführungsbeispiel sind hierzu die einzelnen Rohre auf einem dünnen rohrförmigen Träger elektrisch isoliert aufgebracht, z.B. aufgeklebt. Die entsprechende Kleberschicht, welche die elektrische Isolation der Rohre 20 untereinander und gegenüber dem rohrförmigen Träger 21 gewährleistet, ist in der Figur mit 23 bezeichnet. Es ergibt sich so ein längsgeschlitzter Aufbau, der im Falle eines Quenches des Grundfeldmagneten keine großen Wirbelströme und damit Kräfte entstehen läßt. Auf der Oberfläche des dünnen rohrförmigen Trägers 21 ist dann eine dünne supraleitende Schicht 24 oder ein dünner Belag oder eine entsprechende andere dünne Struktur aus dem supraleitenden Material aufgebracht. Ein durch die Kühlrohre strömendes Kühlmittel wie z.B. Helium-Abgas oder flüssiger Stickstoff dient dann im Betriebszustand des Magnetsystems zur Aufrechterhaltung der Supraleitungseigenschaften der Schicht 24. Für die Auferregungsphase können zusätzlich noch in der Figur nicht dargestellte Heizvorrichtungen an dem Strahlungsschild 18a angebracht sein, um so eine Normalleitung der Schicht 24 während dieser Phase zu gewährleisten. Eine derartige Heizvorrichtung kann z.B. auch ein während dieser Phase durch die Rohre 20 strömendes Medium darstellen, dessen Temperatur hinreichend hoch ist, um die Schicht 24 über die kritische Temperatur T_{c} zu erwärmen. Auf derartige besondere Heizvorrichtungen kann jedoch vorteilhaft verzichtet werden, wenn bei entsprechender Dimensionierung der supraleitenden Schicht 24 erreicht werden kann, daß die Stromtragfähigkeit der Schicht 24 aufgrund von in ihr angefachter Abschirmströme überschritten wird.

Der dünne rohrförmige Träger 21 kann aus einem elektrisch schlecht-leitenden Blech wie z.B. aus Stahl oder aus Kunststoff bestehen. Gegebenenfalls ist es auch möglich, auf den rohrförmigen Träger 21 zu verzichten, wenn die untereinander mechanisch verbundenen Kühlrohre 20 eine hinreichend eigenstabile zylindrische Struktur darstellen. In diesem Falle wird vorzugsweise auf der Innenseite des Hohlzylinders die dünne supraleitende Schicht 24 direkt aufgebracht.

Es ist auch denkbar, einen konventionellen, elektrisch und thermisch gut-leitenden, ungeschlitzten Strahlungsschild - z.B. aus Aluminium - als Träger mit dem besonderen supraleitenden Material zu beschichten. Dann entfällt allerdings der Vorteil der geringeren Kräfte auf die Wirbelströme im Schild bei einem Quench des Grundfeldmagneten.

Aus Figur 4 geht eine weitere Ausführungsform eines erfindungsgemäßen, längsgeschlitzten Strahlungsschildes in Figur 3 entsprechender Darstellung schematisch hervor. Dieser mit 18b bezeichnete Strahlungsschild setzt sich aus in Umfangsrichtung gesehen überlappenden, elektrisch gegeneinander isolierten Metallstreifen 26 zusammen, die zu einer rohrförmigen Struktur mittels einer elektrischen Isolation 27 verbunden sind. Die Metallstreifen 26 müssen hierbei aus einem gut-wärmeleitenden Material bestehen, um die auftretende Wärmelast in axialer (z-)Richtung an die Stirnseiten des Strahlungsschildes abführen zu können, wo sie thermisch an entsprechend kalte Teile des Magnetspulensystems angekoppelt sind. Auf der Oberfläche dieser rohrförmigen Struktur ist wiederum eine supraleitende Schicht 24 aus einem geeigneten Hoch-T_{c}-Supraleitungsmaterial abgeschieden.

Es ist bei allen Ausführungsformen etwas günstiger, die supraleitende Schicht auf der Innenseite eines eventuell vorhandenen rohrförmigen Trägers statt auf der Außenseite anzuordnen. Dann muß nämlich das Gradientenfeld nicht erst durch das Metall des Trägers hindurchdiffundieren, wobei Wärmeeinträge bei hohen Gradientenbetriebsfrequenzen auftreten würden.

Gemäß der in Figur 5 gezeigten schematischen Aufsicht auf eine in den Figuren 3 und 4 angedeutete supraleitende Schicht 24 braucht diese Schicht nicht unbedingt flächig ausgeführt zu sein. Vielmehr ist auch eine Netzstruktur 24a mit rechteckförmigen oder auch mit rautenförmigen oder ringförmigen Maschen 28 möglich, die nicht besonders gleichmäßig zu sein brauchen. Die Größe dieser Maschen kann mikrofein bis zu etwa handtellergroß vorgesehen werden. Die Abmessungen und die Gestalt der Maschen 28 wird dabei so gewählt, daß in ihnen Kreisströme erzeugt werden, die gerade so groß sind, daß sie den Durchtritt des von den Gradientenspulen erzeugten magnetischen Flusses in Richtung auf die Grundfeldspulen unterbinden.

Werden für die Netzstruktur 24a insbesondere Drähte oder Bänder aus dem speziellen supraleitenden Material verwendet, so müssen sie in den Knoten bzw. Überlappungsbereichen möglichst gut leitfähig verbunden werden. Dies kann z.B. durch Quetschen, Ultraschallschweißen, Löten mit supraleitendem Lot oder einer Kombination dieser Maßnahmen erfolgen. Entsprechende Verbindungstechniken sind allgemein für ein Verbinden von Supraleitern bei einer Magnetfertigung bekannt.

Neben der in Figur 5 gezeigten Netzstruktur 24a ist es ferner möglich, einen Strahlungsschild auch mit einzelnen vorgefertigten Elementen aus dem besonderen supraleitenden Material flächig zu versehen. Ein entsprechendes Ausführungsbeispiel ist in Figur 6 als Aufsicht angedeutet. Wie aus dieser Figur hervorgeht, wird eine schicht- oder belagähnliche Struktur 24b aus dem besonderen supraleitenden Material mit einzelnen Flächenelementen 30 gebildet, die untereinander nicht notwendigerweise elektrisch leitend verbunden zu sein brauchen. Gemäß dem dargestellten Ausführungsbeispiel wurde sogar davon ausgegangen, daß zwischen den einzelnen Elementen 30 jeweils schmale, in der Figur übertrieben breit dargestellte isolierende Zwischenräume 31 vorhanden sind. Stattdessen können die Flächenelemente auch so angeordnet werden, daß sie sich in schmalen Randstreifen überlappen, ohne daß sie untereinander elektrisch leitend verbunden sind. Dies ist vorteilhaft, wenn eine besonders gute Abschirmwirkung erzielt werden soll. Die einzelnen Flächenelemente 30 können beispielsweise mit etwa handtellergroßen Platten erstellt werden, die aus einem Substratmaterial bestehen, das als Träger für die bekannten supraleitenden Hoch-T_{c} -Materialien geeignet ist. Als Substratmaterialien kommen hierbei insbesondere Al₂O₃, ZrO₂ , MgO oder vorzugsweise SrTiO₃ in Frage (vgl. z.B. "Applied Physics Letters", Vol. 51, No. 11, 14.9.1987, Seiten 852 bis 854). Daneben ist auch eine entsprechende Beschichtung von Folienmaterial als Substrat möglich. Nach dem Beschichtungsvorgang mit dem besonderen supraleitenden Material werden dann die so erhaltenen Flächenelemente 30 auf der Innen- oder Außenseite des Strahlungsschildes angebracht, beispielsweise angeklebt.

## Patentansprüche

1. Magnetspulensystem (2) einer Anlage zur Kernspintomographie mit supraleitenden Spulen (11-13) zur Erzeugung eines homogenen magnetischen Grundfeldes, mit normalleitenden Spulen (8) innerhalb des von den Grundfeldspulen umgrenzten Innenraumes zur Ausbildung magnetischer Feldgradienten sowie mit mindestens einem gekühlten Strahlungsschild (18,18a,18b) aus elektrisch und thermisch leitendem Material, der zwischen den Gradientenspulen und den supraleitenden Grundfeldspulen angeordnet ist, **dadurch gekennzeichnet**, daß der Strahlungsschild (18, 18a, 18b) zur Abschirmung des magnetischen Gradientenfeldes nach außen supraleitendes Material 2. Art eines Hochtemperatursupraleiters (24,24a,24b) umfaßt, das sich bei einem Auferregungsvorgang der Grundfeldspulen (11 bis 13) im normalleitenden Zustand und während des ungestörten Betriebszustandes des Magnetspulensystems (2) im supraleitenden Zustand befindet.

2. Magnetspulensystem nach Anspruch 1, **dadurch gekennzeichnet**, daß das supraleitende Material als dünne Schicht (24, 24a, 24b) oder als dünner Belag auf der Innen- oder Außenseite des Strahlungsschildes (18, 18a, 18b) aufgebracht ist.

3. Magnetspulensystem nach Anspruch 2, **dadurch gekennzeichnet**, daß die supraleitende Schicht (24a) oder der supraleitende Belag des Strahlungsschildes (18, 18a, 18b) maschenartig strukturiert ist.

4. Magnetspulensystem nach Anspruch 3, **dadurch gekennzeichnet**, daß Maschen (28) aus supraleitenden Drähten oder Bändern ausgebildet sind, die miteinander elektrisch gutleitend verbunden sind.

5. Magnetspulensystem nach Anspruch 2, **dadurch gekennzeichnet**, daß die supraleitende Schicht (24b) oder der supraleitende Belag des Strahlungsschildes (18, 18a, 18b) aus mehreren vorgefertigten Flächenelementen (30) zusammengesetzt ist.

6. Magnetspulensystem nach Anspruch 5, **dadurch gekennzeichnet**, daß die Flächenelemente (30) der supraleitenden Schicht (24b) oder des supraleitenden Belages Platten oder Folien sind, welche mit dem supraleitenden Material beschichtet sind.

7. Magnetspulensystem nach Anspruch 5 oder 6, **dadurch gekennzeichnet**, daß sich die Flächenelemente (30) in schmalen Randstreifen überlappen.

8. Magnetspulensystem nach einem der Ansprüche 1 bis 7, **dadurch gekennzeichnet**, daß der Strahlungsschild (18, 18a, 18b) mit einer Heizvorrichtung zum Erhitzen des supraleitenden Materials über seine kritische Sprungtemperatur (T_{c}) während des Auferregungsvorganges der Grundfeldspulen (11 bis 13) ausgestattet ist.

9. Magnetspulensystem nach einem der Ansprüche 1 bis 7, **dadurch gekennzeichnet**, daß eine Dimensionierung des supraleitenden Materials so gewählt ist, daß während des Auferregungsvorganges der Grundfeldspulen (11 bis 13) vor Erreichen des Betriebsstromes die kritische Stromtragfähigkeit des supraleitenden Materials überschritten ist.

10. Magnetspulensystem nach einem der Ansprüche 1 bis 9, **dadurch gekennzeichnet**, daß Mittel zur thermischen Abkopplung des Strahlungsschildes (18, 18a, 18b) während des Auferregungsvorganges der Grundfeldspulen (11 bis 13) von einer ihn während des Betriebszustandes kühlenden Einrichtung vorgesehen sind.

11. Magnetspulensystem nach einem der Ansprüche 1 bis 10, **dadurch gekennzeichnet**, daß der Strahlungsschirm (18, 18a, 18b) einen längsgeschlitzten Aufbau seiner metallischen Teile aufweist.

12. Magnetspulensystem nach einem der Ansprüche 1 bis 11,**dadurch gekennzeichnet**, daß der Strahlungsschild (18a) dünnwandige Kühlmittelrohre (20) enthält, die in axialer Richtung des Schildes parallel zueinander und untereinander elektrisch schlecht-leitend angeordnet sind.

13. Magnetspulensystem nach einem der Ansprüche 1 bis 11, **dadurch gekennzeichnet**, daß der Strahlungsschild (18b) dünne Metallstreifen (26) aus thermisch gut-leitendem Material enthält, die in axialer Richtung des Schildes parallel zueinander angeordnet sind und sich in Umfangsrichtung des Schildes gesehen überlappen, wobei sie untereinander elektrisch isoliert sind.

14. Magnetspulensystem nach einem der Ansprüche 1 bis 13, **dadurch gekennzeichnet**, daß das supraleitende Material eine supraleitende Y-Ba-Cu-O-Phase enthält.

## Claims

1. A magnetic coil system (2) of a nuclear spin tomography apparatus with superconducting coils (11-13) for the generation of a homogeneous magnetic base field, with normal-conducting coils (8) within the internal space defined by the base field coils for the development of magnetic field gradients, and with at least one cooled radiation shield (18, 18a) composed of electrically and thermally conducting material which is arranged between the gradient coils and the super-conducting base field coils, characterised in that the radiation shield (18, 18a, 18b) for the shielding of the magnetic gradient field towards the exterior comprises superconducting material of the 2nd type of a high temperature superconductor (24, 24a, 24b) which during an excitation build-up process of the base field coils (11 to 13) is in the normal-conducting state and during the undisturbed operating state of the magnetic coil system (2) is in the superconducting state.

2. A magnetic coil system as claimed in Claim 1, characterised in that the superconducting material is applied in the form of a thin layer (24, 24a, 24b) or a thin coating to the interior or exterior of the radiation shield (18, 18a, 18b).

3. A magnetic coil system as claimed in Claim 2, characterised in that the superconducting layer (24a) or the superconducting coating of the radiation shield (18, 18a, 18b) has a mesh-like structure.

4. A magnetic coil system as claimed in Claim 3, characterised in that meshes (28) are formed from superconducting wires or strips which are electrically highly conductively connected to one another.

5. A magnetic coil system as claimed in Claim 2, characterised in that the superconducting layer (24b) or the superconducting coating of the radiation shield (18, 18a, 18b) is composed of a plurality of prefabricated planar elements (30).

6. A magnetic coil system as claimed in Claim 5, characterised in that the planar elements (30) of the superconducting layer (24b) or of the superconducting coating are plates or foils which are coated with the superconducting material.

7. A magnetic coil system as claimed in Claim 5 or 6, characterised in that the planar elements (30) overlap in narrow edge strips.

8. A magnetic coil system as claimed in one of Claims 1 to 7, characterised in that the radiation shield (18, 18a, 18b) is equipped with a heating device for heating the superconducting material above its critical transition temperature (T_{c}) during the excitation build-up process of the base field coils (11 to 13).

9. A magnetic coil system as claimed in one of Claims 1 to 7, characterised in that the dimensions of the superconducting material are selected such that during the excitation build-up process of the base field coils (11 to 13) before the operating current is reached the critical current carrying capacity of the super-conducting material is exceeded.

10. A magnetic coil system as claimed in one of Claims 1 to 9, characterised in that means are provided for thermally decoupling the radiation shield (18, 18a, 18b) during the excitation build-up process of the base field coils (11 to 13) from a device which cools said radiation shield during the operating state.

11. A magnetic coil system as claimed in one of Claims 1 to 10, characterised in that the radiation shield (18, 18a, 18b) possesses a longitudinally slotted construction of its metallic parts.

12. A magnetic coil system as claimed in one of Claims 1 to 11, characterised in that the radiation shield (18a) contains thin-walled coolant tubes (20) which are arranged in parallel to one another in the axial direction of the shield and so as to be electrically poorly conducting in relation to one another.

13. A magnetic coil system as claimed in one of Claims 1 to 11, characterised in that the radiation shield (18b) contains thin metal strips (26) composed of thermally highly conducting material which are arranged in parallel to one another in the axial direction of the shield and considered in the circumferential direction of the shield overlap whilst being electrically insulated from one another.

14. A magnetic coil system as claimed in one of Claims 1 to 13, characterised in that the superconducting material contains a superconducting Y-Ba-Cu-O-phase.

## Revendications

1. Système de bobines magnétiques (2) d'une installation de tomographie à résonance magnétique nucléaire, comportant des bobines supraconductrices (11 - 13) pour produire un champ fondamental magnétique homogène, des bobines normalement conductrices (8) situées à l'intérieur du volume interne délimité par les bobines de champ fondamental pour la génération de gradients de champ magnétique ainsi qu'au moins un écran anti-rayonnement refroidi (18, 18a, 18b), constitué d'une matière électriquement et thermiquement conductrice et disposé entre les bobines de gradients et les bobines de champ fondamental supraconductrices, caractérisé en ce que l'écran anti-rayonnement (18, 18a, 18b) comporte, pour arrêter le champ de gradients magnétiques vers l'extérieur, une matière supraconductrice de deuxième type d'un supraconducteur haute température (24, 24a, 24b), qui se trouve dans un état normalement conducteur lors d'un processus d'excitation des bobines de champ fondamental (11 à 13) et qui se trouve dans un état supraconducteur pendant l'état de fonctionnement non perturbé du système de bobines magnétiques (2).

2. Système de bobines magnétiques selon la revendication 1, caractérisé en ce que la matière supraconductrice est disposée sous forme d'une couche mince (24, 24a, 24b) ou bien d'un revêtement mince, sur le côté intérieur ou sur le côté extérieur de l'écran anti-rayonnement (18, 18a, 18b).

3. Système de bobines magnétiques selon la revendication 2, caractérisé en ce que la couche supraconductrice (24a) ou le revêtement supraconducteur de l'écran anti-rayonnement (18, 18a, 18b) a une structure analogue à un maillage.

4. Système de bobines magnétiques selon la revendication 3, caractérisé en ce que les mailles (28) sont formées par des fils ou des bandes supraconducteurs qui sont reliées entre elles de façon électriquement conductrice.

5. Système de bobines magnétiques selon la revendication 2, caractérisé en ce que la couche supraconductrice (24b) ou le revêtement supraconducteur de l'écran anti-rayonnement (18, 18a, 18b) est composé de plusieurs éléments superficiels préfabriqués (30).

6. Système de bobines magnétiques selon la revendication 5, caractérisé en ce que les éléments superficiels (30) de la couche supraconductrice (24b) ou du revêtement supraconducteur sont des plaques ou des feuilles qui sont revêtues de la matière supraconductrice.

7. Système de bobines magnétiques selon la revendication 5 ou 6, caractérisé en ce que les éléments superficiels (30) se recouvrent dans des bandes marginales étroites.

8. Système de bobines magnétiques selon l'une des revendications 1 à 7, caractérisé en ce que l'écran anti-rayonnement (18, 18a, 18b) est équipé d'un dispositif de chauffage pour chauffer la matière supraconductrice au-dessus de sa température critique de changement brusque (T_{c}) pendant le processus d'excitation des bobines de champ fondamental (11 à 13).

9. Système de bobines magnétiques selon l'une des revendications 1 à 7, caractérisé en ce qu'un dimensionnement de la matière supraconductrice est choisi de telle sorte que, pendant le processus d'excitation des bobines de champ fondamental (11 à 13), la conductivité critique de la matière supraconductrice soit dépassée avant que le courant de service soit atteint.

10. Système de bobines magnétiques selon l'une des revendications 1 à 9, caractérisé en ce qu'il est prévu des moyens pour le découplage thermique de l'écran anti-rayonnement (18, 18a, 18b) pendant le processus d'excitation des bobines de champ fondamental (11 à 13) par un dispositif refroidissant l'écran pendant l'état de marche.

11. Système de bobines magnétiques selon l'une des revendications 1 à 10, caractérisé en ce que l'écran anti-rayonnement (18, 18a, 18b) comporte pour ses parties métalliques un agencement avec fente longitudinale.

12. Système de bobines magnétiques selon l'une des revendications 1 à 11, caractérisé en ce que l'écran anti-rayonnement (18a) contient des tubes de réfrigérant à parois minces (20), qui sont disposés, dans la direction axiale de l'écran, parallèlement les uns aux autres et avec mauvaise conduction électrique entre eux.

13. Système de bobines magnétiques selon l'une des revendications 1 à 11, caractérisé en ce que l'écran anti-rayonnement (18b) contient de minces bandes métalliques (26) formées d'une matière thermiquement bonne conductrice, qui sont disposées parallèlement les unes aux autres dans une direction axiale de l'écran et qui se recouvrent, en les considérant dans la direction circonférencielle de l'écran, en étant électriquement isolées les unes des autres.

14. Système de bobines magnétiques selon l'une des revendications 1 à 13, caractérisé en ce que la matière supraconductrice contient une phase Y-Ba-Cu-O supraconductrice.
